Europäisches Patentamt

European Patent Office

Office européen des brevets

(11) Veröffentlichungsnummer: **0 081 176**
**A1**

(12) ## EUROPÄISCHE PATENTANMELDUNG

(21) Anmeldenummer: **82111016.0**

(22) Anmeldetag: **29.11.82**

(51) Int. Cl.³: **C 23 C 15/00**

(30) Priorität: **07.12.81 DE 3148354**

(43) Veröffentlichungstag der Anmeldung:
**15.06.83 Patentblatt 83/24**

(84) Benannte Vertragsstaaten:
**CH DE FR GB LI NL**

(71) Anmelder: **SIEMENS AKTIENGESELLSCHAFT**
**Berlin und München Wittelsbacherplatz 2**
**D-8000 München 2(DE)**

(72) Erfinder: **Pachonik, Horst, Dipl.-Phys.**
**Lindenring 135**
**D-8028 Taufkirchen(DE)**

(54) **Vorrichtung zur Kathodenzerstäubung eines Metalles.**

(57) Bei einer Vorrichtung zur Kathodenzerstäubung (Sputtern) sind das Target (3) und die Halterung (1) durch eine Verschraubung (5) verbunden. Zwischen dem Target (3) und der Halterung (1) ist eine wärmeleitende Schicht (4) angeordnet, die entweder aus einer wärmeleitenden Paste, einem Metallpulver oder Metallfolien besteht. An der Unterseite der Halterung (1) befinden sich Rohre (2) zur Wasserkühlung. An der Halterung (1) ist ein Rand (7) angeordnet. Weiterhin weist die Vorrichtung eine Dunkelraumabschirmung (6) auf.

EP 0 081 176 A1

SIEMENS AKTIENGESELLSCHAFT
Berlin und München

Unser Zeichen

81 P 1 1 9 5 .E

0081176

Vorrichtung zur Kathodenzerstäubung eines Metalles

Die Erfindung betrifft eine Vorrichtung zur Kathodenzerstäubung eines Metalles, bei der eine Platte (Target) des zu zerstäubenden Metalles mit einer Halterung unter Zwischenfügung einer wärmeleitenden Schicht verbunden ist, und bei der die Halterung mit einer Kühleinrichtung versehen ist.

Bei derartigen Anlagen zum Kathodenzerstäuben ("Sputtern") wird das Material, das "Target" das mit dem Potential der Kathode verbunden ist, durch Beschuß mit Edelgasionen zerstäubt. Dieser Prozeß wird im Vakuum bei Drücken von etwa $10^{-2}$ bis $10^{-4}$ mbar durchgeführt. Da der Stromfluß einige Ampere betragen kann, wird eine beträchtliche Energie umgesetzt, die über das Target abgeführt werden muß. Aus diesem Grund ist ein guter Wärmekontakt zwischen Target und Targethalterung sowie eine Kühleinrichtung, im allgemeinen eine Wasserkühlung, für die Halterung notwendig.

Der gute Wärmekontakt wird bisher dadurch erreicht, daß das Target auf den Targethalter mit niedrig schmelzenden Legierungen aufgelötet (gebondet) wird. Bei einer guten Verbindung (Bondung) sind im allgemeinen höchstens 60 % der Targetfläche wärmeleitend mit der Halterung verbunden.

Beim Hochleistungssputtern ist die abgetragene Materialmenge so hoch, daß im Dauerbetrieb ein Target nach wenigen Tagen verbraucht ist. Der Targetwechsel ist bei den bekannten Vorrichtungen mit hohem Zeit- und Kostenaufwand verbunden. Aus diesem Grunde wird bisher das Sputtern, für viele Metallisierungsprozesse obgleich es wünschenswert wäre, nicht verwendet.

Aufgabe der Erfindung ist es daher, eine Vorrichtung zur Kathodenzerstäubung anzugeben, bei der das Target einfach und schnell mit der Halterung verbunden werden kann und bei der ein guter Wärmeübergang zwischen Target und Halterung gewährleistet wird.

Diese Aufgabe wird bei einer Vorrichtung der eingangs genannten Art erfindungsgemäß dadurch gelöst, daß die Platte (Target) mit der Halterung verschraubt ist, und daß zwischen der Platte (Target) und der Halterung als wärmeübertragendes Medium eine wärmeleitende Paste angeordnet ist.

Die wärmeleitende Paste enthält vorteilhaft thermisch schwer zersetzbare organische und/oder Silicon-Verbindungen.

Bei einer weiteren Ausführungsform ist die eingangs genannte Vorrichtung erfindungsgemäß dadurch gekennzeichnet, daß die Platte (Target) mit der Halterung verschraubt ist, und daß zwischen der Platte (Target) und der Halterung als wärmeübertragendes Medium ein Metallpulver angeordnet ist.

Das Metallpulver besteht bevorzugt aus Kupfer, Aluminium, Bronze oder Messing und weist vorzugsweise eine Körnung $\geq 5 \, \mu m$ auf.

Bei einer anderen Ausführung ist die eingangs genannte Vorrichtung erfindungsgemäß dadurch gekennzeichnet, daß die Platte (Target) mit der Halterung verschraubt ist und daß zwischen der Platte (Target) und der Halterung als wärmeübertragendes Medium eine Metallfolie angeordnet ist.

Die Metallfolie ist vorteilhaft doppelt gelegt und an den Rändern verschweißt und enthält in ihrem Innern eine gasfreie Wärmeleitpaste. Bevorzugt ist die Metallfolie ca. 50 $\mu$m dick und besteht aus Kupfer oder einer Kupfer-Legierung.

Die erfindungsgemäße Vorrichtung zeichnet sich in vorteilhafter Weise dadurch aus, daß einerseits durch die Verschraubung ein leichtes Lösen und Verbinden des Targets mit der Halterung erfolgen kann und daß weiterhin eine gute Wärmeübertragung zwischen dem Target und der Halterung vorhanden ist.

Die Erfindung wird anhand von Ausführungsbeispielen näher erläutert.

In der Fig. ist ein Schnittbild einer erfindungsgemäßen Vorrichtung dargestellt. Eine Halterung 1 weist an ihrer Unterseite eine Kühleinrichtung auf, die aus von Wasser durchströmten Rohren 2 besteht. Das Target 3 ist unter Zwischenfügung einer wärmeleitenden Schicht 4 mittels der Schraube 5 mit der Halterung 1 verbunden. Durch die wärmeleitende Schicht 4 ~~ist~~ zwischen Target 3 und Halterung 1 ist eine ausreichende Wärmeübertragung gewährleistet, so daß die Sputteranlage mit voller Leistung betrieben werden kann.

Eine erfindungsgemäße Ausführungsform sieht vor, daß die wärmeleitende Schicht 4 aus einer wärmeleitenden Paste besteht, welche organische bzw. Silicon-Verbindungen enthält. Hierbei muß allerdings sichergestellt sein, daß nur gekühlte Zonen mit der Paste bestrichen werden, da sonst die Gefahr besteht, daß Dampfspuren des Kühlmittels in den Sputterraum eintreten.

Bei einer anderen Ausführungsform besteht die wärmeleitende Schicht 4 aus einem Metallpulver, wobei vorzugsweise Kupfer, Aluminium, Bronze oder Messing verwendet wird. Die Körnung des Metallpulvers ist zweckmäßigerweise gleich oder größer als 5 $\mu$m, um eine Verschmierung und einen Staubflug zu vermeiden, was zu Kurzschlüssen zwischen Kathode (das Target 3 ist mit dem Potential der Kathode verbunden) und der Dunkelraumabschirmung 6 führen kann. Bei gleichmäßiger Verteilung des Metallpulvers ist die Wärmeübertragung vom Target 3 zur Halterung 1 genauso gut wie bei aufgelöteten Targets.

Bei einer weiteren Ausführungsform besteht die wärmeleitende Schicht aus einer Metallfolie, die vorteilhaft doppelt gelegt und an den Rändern verschweißt ist. Vor dem Zuschweißen ist in den durch die Metallfolie gebildeten Schlauch eine geringe Menge einer gasfreien Wärmeleitpaste eingefüllt, so daß ein sehr dünnes Kissen beliebiger Gestalt (z. B. mit Aussparungen für die Schraubdurchführung) gebildet wird. Dieses Kissen paßt sich mit seiner Oberfläche genau der Halterung und dem Target an und stellt über seinen Inhalt eine Brücke mit guter Wärmeleitfähigkeit her. Die Metallfolien müssen dafür einerseits so dünn sein, daß sie sich der Oberfläche noch genügend anpassen können, gleichzeitig aber dem Anpreßdruck des Targets 3 standhalten, ohne aufzureißen. Vorteilhaft sind deshalb wegen der leichten Verschweißbarkeit und der Duktilität Kupfer bzw. Kupferlegierungen von etwa 50 $\mu$m Stärke.

Durch die einfache Schraubtechnik ist es möglich, an der
Halterung 1 einen Rand 7 anzuordnen, wobei der Rand 7
so hoch oder etwas höher als das Target 3 ist. Dieser
Rand 7 kann glatt geschliffen sein, so daß keine elektrischen Überschläge vom Rand des Targets 3 zur Dunkelraumabschirmung 6 in Folge erhöhter Feldstärke an
Kratern bzw. Spitzen stattfinden können. Der Rand 7 gewährleistet ein besonders einfaches Einbringen der Wärmeleitschicht 4.

Wie den Ausführungsbeispielen zu entnehmen ist, wird
somit durch die Erfindung eine Vorrichtung zur Kathodenzerstäubung geschaffen, bei der in besonders einfacher
Weise ein Target mit einer Halterung verbunden werden
kann, wobei eine gute Wärmeübertragung zwischen dem
Target und der Halterung gewährleistet ist.

9 Patentansprüche
1 Figur

<u>Patentansprüche</u>

1. Vorrichtung zur Kathodenzerstäubung eines Metalles, bei der eine Platte (Target) des zu zerstäubenden Metalles mit einer Halterung unter Zwischenfügung einer wärmeleitenden Schicht verbunden ist, und bei der die Halterung mit einer Kühleinrichtung versehen ist, d a - d u r c h   g e k e n n z e i c h n e t, daß die Platte (Target) (3) mit der Halterung (1) verschraubt ist, und daß zwischen der Platte (Target) (3) und der Halterung (1) als wärmeübertragendes Medium eine wärmeleitende Paste angeordnet ist.

2. Vorrichtung nach Anspruch 1, d a d u r c h   g e - k.e n n z e i c h n e t, daß die wärmeleitende Paste thermisch schwer zersetzbare organische und/oder Silicon- verbindungen enthält.

3. Vorrichtung zur Kathodenzerstäubung eines Metalles, bei der eine Platte (Target) des zu verstäubenden Metalles mit einer Halterung unter Zwischenfügung einer wärmeleitenden Schicht verbunden ist, und bei der die Halterung mit einer Kühleinrichtung versehen ist, d a d u r c h   g e k e n n z e i c h n e t, daß die Platte (Target) (3) mit der Halterung (1) verschraubt ist, und daß zwischen der Platte (Target) (3) und der Halterung (1) als wärmeübertragendes Medium ein Metallpulver angeordnet ist.

4. Vorrichtung nach Anspruch 3, d a d u r c h   g e - k e n n z e i c h n e t, daß das Metallpulver aus Kupfer, Aluminium, Bronze oder Messing besteht.

5. Vorrichtung nach Anspruch 3 oder 4, d a d u r c h   g e- k e n n z e i c h n e t, daß die Körnung des Metall- pulvers $\geq$ 5 µm ist.

6. Vorrichtung zur Kathodenzerstäubung eines Metalles, bei der eine Platte (Target) des zu zerstäubenden Metalles mit einer Halterung unter Zwischenfügung einer wärmeleitenden Schicht verbunden ist, und bei der die Halterung mit einer Kühleinrichtung versehen ist, d a - d u r c h   g e k e n n z e i c h n e t, daß die Platte (Target) (3) mit der Halterung (1) verschraubt ist, und daß zwischen der Platte (Target) (3) und der Halterung (1) als wärmeübertragendes Medium eine Metallfolie angeordnet ist.

7. Vorrichtung nach Anspruch 6, d a d u r c h   g e - k e n n z e i c h n e t, daß die Metallfolie doppelt gelegt und an den Rändern verschweißt ist und in ihrem Innern eine gasfreie Wärmeleitpaste enthält.

8. Vorrichtung nach Anspruch 6 oder 7, d a d u r c h g e k e n n z e i c h n e t, daß die Metallfolie ca. 50 $\mu$m dick ist und aus Kupfer oder einer Kupfer-Legierung besteht.

9. Vorrichtung nach einem der Ansprüche 1 bis 8, d a - d u r c h   g e k e n n z e i c h n e t, daß die Halterung (1) einen Rand (7) aufweist.

Europäisches
Patentamt

# EUROPÄISCHER RECHERCHENBERICHT

| EINSCHLÄGIGE DOKUMENTE | | | | EP 82111016.0 |
|---|---|---|---|---|
| Kategorie | Kennzeichnung des Dokuments mit Angabe, soweit erforderlich, der maßgeblichen Teile | | Betrifft Anspruch | KLASSIFIKATION DER ANMELDUNG (Int. Cl. ³) |
| Y | <u>EP - A1 - 0 024 355</u> (SIEMENS AKTIENGESELLSCHAFT)<br><br>* Fig.; Ansprüche *<br><br>-- | | 1,3,4 | C 23 C 15/00 |
| X | <u>DE - A1 - 2 923 174</u> (DEMETRON GESELLSCHAFT FUR ELEKTRONIK-WERKSTOFFE GMBH)<br><br>* Ansprüche *<br><br>-- | | 1,3,6, 8 | |
| Y | PATENTS ABSTRACTS OF JAPAN, un-examined applications, C Field, Vol. 4, No. 151, 23. Oktober 1980<br>THE PATENT OFFICE JAPANESE GOVERN-MENT<br>Seite 96 C 28<br><br>* Kokai No. 55-97 473 (MURATA SEISAKUSHO) *<br><br>-- | | 1 | |
| | | | | **RECHERCHIERTE SACHGEBIETE (Int. Cl. ³)** |
| Y | PATENTS ABSTRACTS OF JAPAN, un-examined applications, C Field, Vol. 4, No. 140, 3. Oktober 1980<br>THE PATENT OFFICE JAPANESE GOVERN-MENT<br>Seite 104 C 26<br><br>* Kokai No. 55-89 471 (MURATA SEISKUSHO) *<br><br>-- | | 1,9 | C 23 C |
| Der vorliegende Recherchenbericht wurde für alle Patentansprüche erstellt. | | | | |
| Recherchenort<br>WIEN | Abschlußdatum der Recherche<br>04-02-1983 | | | Prüfer<br>SLAMA |

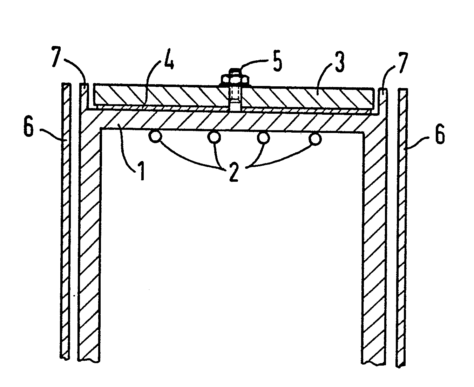

| EINSCHLÄGIGE DOKUMENTE | | | KLASSIFIKATION DER ANMELDUNG (Int. Cl.³) |
|---|---|---|---|
| Kategorie | Kennzeichnung des Dokuments mit Angabe, soweit erforderlich, der Maßgeblichen Teile | betrifft Anspruch | |
| Y | PATENTS ABSTRACTS OF JAPAN, un-examined applications, C Field, Vol. 3, No. 109, 12. September 1979 THE PATENT OFFICE JAPANESE GOVERN-MENT Seite 107 C 58 * Kokai No. 54-88 885 (MATSUSHITA DENKI SANGYO K.K.) * ---- | 1,9 | |
| | | | RECHERCHIERTE SACHGEBIETE (Int. Cl.³) |